# EUROPEAN PATENT APPLICATION

(11) **EP 1 832 636 A1**
(43) Date of publication of application: **12.09.2007**
(21) Application number: 07004902.8
(22) Date of filing: 09.03.2007
(51) Int. Cl.: C09J 5/06, C09J 163/00, H01B 1/22, H01R 4/04, H05K 3/32

(54) **Anisotropic conductive adhesive**

(30) Priority: 10.03.2006 US 373484
(71) Applicant: National Starch and Chemical Investment Holding Corporation, New Castle, Delaware 19720 (US)
(72) Inventor: Cheng, Chih-Min, Westford MA 01886 (US); Shah, Jayesh P., Plaistow NH 03865 (US); Xia, Bo, Lexington MA 02420 (US)
(74) Representative: Held, Stephan

(57) **Abstract**

An anisotropic conductive adhesive that provides strong adhesion to metals and organic substrates to generate stable and reliable electric interconnects. The adhesive provides the benefits of short thermocompression bond time at low temperatures. The adhesive contains cationic curable resin, latent cationic catalyst that thermally cures the resin at high speeds and low temperatures, conductive filler, optionally a film forming thermoplastic solid resin and optionally nano size filler. The optional nano filler provides the benefit of reducing the coefficient of thermal energy mismatch, improving the adhesion strength and reducing the total heat of reaction for the system.

## Description

### FIELD OF THE INVENTION

This invention relates to compositions that are suitable for use as conductive materials in microelectronic devices or semiconductor packages to provide electrically stable interconnections.

### BACKGROUND OF THE INVENTION

Conductive compositions are used for a variety of purposes in the fabrication and assembly of semiconductor packages and microelectronic devices. For example, conductive adhesives are used to bond integrated circuit chips to substrates (die attach adhesives) or circuit assemblies to printed wire boards (surface mount conductive adhesives).

More specifically, anisotropic conductive adhesives have been utilized for interconnect of various electronic hardware, including chip-on-glass assembly, flip chip on flex assembly, contactless smart-card module assembly and bard chop attach on flexible or rigid substrates. Anisotropic conductive adhesives provide the benefits of the elimination of underfill, low temperature processing, high I/O numbers and, because there is no direct contact between particles, fine interconnection pitch for packaging applications, especially with flip chip applications. The use of anisotropic conductive adhesives provides cost savings due to their simple and flexible processing capabilities. Further, environmental benefits in reductions of hazardous materials content and precious metals are obtained via the use of anisotropic conductive adhesives.

Anisotropic conductive adhesives consist of an adhesive polymer matrix having fine conductive fillers of metallic or metal-coated polymer particles. The volume fraction of particles is well below the percolation threshold, usually between 5 and 10%, and the particles are usually in the range of about 3 to 10 µm in diameter. Due to the low volume fraction, there are no continuous conductive paths among the particles in the x-y plane. The adhesive therefore conducts electricity only in the z direction.

Drawbacks of anisotropic conductive adhesives are that they require high bonding temperatures and long bonding times. Further drawbacks include short shelf and working lives. It would be an advantage, therefore, to provide an anisotropic conductive adhesive that forms electrically stable assemblies for use in semiconductor packaging operations. It would also be advantageous to provide an anisotropic conductive adhesive which would provide the benefits of improved shelf and work lives, low bonding temperature and short bonding time.

### SUMMARY OF THE INVENTION

The present invention discloses an anisotropic conductive adhesive that provides strong adhesion to metals and organic substrates to generate stable and reliable electric interconnects. The adhesive provides the benefits of short thermocompression bond time at low temperatures. The adhesive contains cationic curable resin, latent cationic catalyst that thermally cures the epoxy resin at high speeds and low temperatures, conductive filler, optionally a film forming thermoplastic solid resin and optionally nano size filler. The optional nano size filler provides the benefit of reducing the coefficient of thermal expansion mismatch, improving the adhesion strength and reducing the total heat of reaction for the system.

### DETAILED DESCRIPTION OF THE INVENTION

The anisotropic conductive adhesive of the present invention combines fast curing times, low curing temperatures and enhanced stability at room temperature. The adhesive is capable of thermocompression bonding within 20 seconds at temperatures less than 200°C, and preferably within 10 seconds at temperatures less than 175°C. In a preferred embodiment, the adhesive is capable of thermocompression bonding within 3 seconds at temperatures in the range of 150°C. The adhesive provides strong adhesion to metal and organic substrates, has a work life of at least a week at ambient temperatures and forms stable electrical interconnections after bonding.

The anisotropic adhesive comprises one or more cationic curable resin, one or more thermal latent cationic catalyst, one or more conductive filler, optionally one or more film forming thermoplastic solid resin and optionally one or more nano size filler. Additional additives, such as thixotropic agents, air release agents, corrosion inhibitors, curing agents, catalysts, diluents and adhesion promoters may also be added as desired.

The cationic curable resin may be an epoxy resin such as a cycloaliphatic epoxy resin. Cycloaliphatic epoxy resins that may be utilized with the invention include, but are not limited to, vinylcyclohexane dioxide, bis(3,4-epoxycyclohexyl)adipate, 3,4-epoxycytlohexylmethyl-3,4-epoxycyclohexanecarboxylate, and 2-(3,4-epoxycyclohexyl-5,5-spiro-3,4-epoxy)cyclohexane-metadioxane and mixtures thereof. A preferred cycloaliphatic epoxy resin is reinforced with silica nanoparticles and is commercially available as NANOPOX , commercially available from Hanse Chemie. The silica phase of that epoxy resin consists of surface-modified, synthetic SiO₂-nanospheres which are less than 100 nm in diameter and have extremely narrow particle size distribution. Non-epoxy resins that may be utilized include, but are not limited to, oxetane and vinyl ether. The composition contains in the range of about 5 to about 98 weight percent cationic curable resin and preferably in the range of about 40 to about 60 weight percent of the cationic curable resin.

One or more latent cationic catalysts are included in the composition. The latent cationic catalyst may be a strong acid catalyst of the type commonly referred to as a super acid. The catalyst provides thermal curing of the cycloaliphatic resin at high speeds and low temperatures. Among the latent cationic catalysts are triarylsulfonium hexafluoroantimonate salt, triarylsulfonium hexafluorophosphate salt, (tolycumyl} iodonium tetrakis (pentafluorophenyl) borate, bis(dodecylphenyl)iodonium hexafluoroantimonate, ( iodonium,(4,-methylphenyl)(4-(2-methylpropyl)phenyl),hexafluorophosphate), octyl diphenyliodonium hexafluroantimonate, diaryliodonium salts, benzylsulfonium salts, phenacylsulfonium salts, N-benzylpyridinium salts, N-benzylpyrazinium salts, N-benzylammonium salts, phosphonium salts, hydrazinium salts, ammonium borate salts, and mixtures thereof. A preferred latent cationic catalyst has a low pKa value such as a super acid catalyst such as ammonium/antimony hexafluoride, commercially available from King Industries Inc. as K-PURE epoxy catalyst. The latent cationic catalyst is utilized in the range of about 0.1 to about 10 weight percent of the composition and preferably in the range of about 0.5 to about 3 weight percent of the composition.

One or more conductive fillers are utilized in the composition. By the judicious choice of filler, these compositions can be formulated to give a broad range of resistivity, conductivity, capacitance, or dielectric properties as needed for the specific circuit component. Providing the precise type and amount of filler for obtaining the electrical properties desired for a specific end use application is within the expertise of one skilled in the art. It will be understood that all resistors necessarily exhibit some conductance, and all conductors exhibit some resistance, and that resistors arid conductors form a continuum of resistance and conductance depending on the specific property of the individual material. This continuum is also the case for dielectrics and capacitors. Exemplary conductive fillers include, but are not limited to, silver, copper, gold, palladium, platinum, nickel, gold or silver-coated nickel, carbon black; carbon fiber, graphite, aluminum, indium tin oxide, silver coated copper, silver coated aluminum, metallic coated glass spheres, metallic coated filler, metallic coated polymers, silver coated fiber, silver coated spheres, and antimony doped tin oxide. The conductive filler is utilized in the range of about 1 to about 60 weight percent of the composition and preferably from about 5 to about 30 weight percent of the composition.

One or more film-forming thermoplastic solid resins may optionally be added to the composition. Exemplary resins include any of the resins currently used throughout the industry, such as, epoxies and/or acrylics, phenoxy resin, thermoplastic polyesters, polyamides, polyurethanes, polyolefins, polysulfide rubber, nitrile rubber and mixtures thereof. The formulations and physical properties of the resins are known to those skilled in the art. The film-forming thermoplastic solid resin is utilized in the range of about 10 to about 80 weight percent of the composition and preferably from about 20 to about 50 weight percent of the composition.

Optionally, conductive and/or non-conductive nanospheres may be added to the composition. The nanospheres are preferably agglomerate-free and dispersed into the epoxy resin matrix to result in a low viscosity anisotropic conductive adhesive. The nanospheres reinforce the composition without an excessive viscosity increase as is often caused by other reinforcing additives such as fumed silica. The nanospheres do not interfere with the electrical interconnections even when loaded at a high volume. The addition of nanospheres provides benefits when shipping the composition as opposed to shipping other high reactive systems in that the nanospheres reduce the heat of reaction of the composition. Thermal reliability is enhanced in the composition containing nanospheres by a reduction in the coefficient of thermal expansion mismatch. Further, the addition of nanospheres improves the cure properties, such as glass transition temperature, and the rheology of the composition. Among the conductive nanospheres that may be utilized are nano silver, nano aluminum, nano copper, nano nickel, carbon nanotubes and mixtures thereof. Among the non-conductive nanospheres that may be utilized are nano silica, nano alumina, nano clay and mixtures thereof. The composition contains in the range of about 10 to about 60 weight percent nano size filler, and preferably in the range of about 20 to about 40 weight percent nano size filler.

One or more of curing agents, catalysts, reactive and/or non-reactive diluents, adhesion promoters, corrosion inhibitors and other ingredients may be added as desired. Exemplary corrosion inhibitors include 1,10-phenathiodine, phenothiazine, benzotriazole, benzimidazole, mercaptobenzothiazole , dicyandiamide, 3-isoprolyamino-1-butyne, propargyl quinolinium bromide, 3-benzylamino-1-butyne, dipropargl ether, dipropargyl thioether, propargyl caproate, dianimoheptane, phenathroline, amine, diamine, triamine, hexamethyleneimide, decamethyleneimide, hexamethyleneiminebenzoate, hexamethyleneimine-3,5-dinitrobenzoate, hexamethylenetetramin, d-oximino-b-vinyl quinuclidine, aniline, 6-N-ethyl purine, 1-ethylamino-2-octadecylimidazoline, morpholine, ethanolamine, aminophenol, 2-hydroxyquinoline, 6-hydroxyquinoline, 8-hydroxyquinoline, pyridine and its derivatives, quinoline and its derivatives, acridine, imidazole and its derivatives, toluidine, mercaptan, thiophenol and its derivates, sulfide, sulfoxide, thiophosphate, thiourea, piperidine and mixtures thereof.

Exemplary reactive diluents are glycidyl ethers, for example, 1,4-butanediol diglycidyl ether; vinyl ethers, for example, ethylene vinyl ether, and vinyl esters, for example, ethylene vinyl ester, and acrylates, for example, methyl methacrylate. An exemplary nonreactive diluent is butyl carbitol. Exemplary adhesion promoters are silanes and polyvinyl butyrol.

In another embodiment, this invention is a method of enhancing the electrical stability of a conductive composition comprising utilizing an anisotropic conductive adhesive containing one or more cationic curable epoxy resin, one or more latent cationic super acid catalyst, one or more conductive filler, optionally one or more film forming thermoplastic solid resin and optionally one or more nano size non-conductive filler. According to the method, the anisotropic conductive adhesive of the present invention is applied to a substrate for bonding electronic components together. In a further embodiment, the invention comprises an electronic device containing the anisotropic conductive adhesive disclosed herein.

The invention can be further described by the following example.
EXAMPLE. Two samples of an anisotropic conductive adhesive were prepared as follows (all amounts of ingredients are indicated by weight percent). A mixture of resin is added to a mixing vessel equipped with a propeller stirrer. The catalyst is added and mixed until fully dissolved. Adhesion promoter and surfactant are then added, followed by adding conductive filler and the composition is mixed for 5-10 minutes. The mixture is de-gassed for 5 minutes in a vacuum chamber at a pressure of >28 in Hg. The formulations of the two samples are set out in Table 1.

**Table 1. Anisotropic Conductive Adhesive Formulations**

| Ingredient | Sample A | Sample B |
|---|---|---|
| | (weight %) | (weight %) |
| Silica Nanoparticle Reinforced Cycloaliphatic Epoxy Resin¹ | 87.72 | 74.12 |
| Latent Cationic Curative² | 1.36 | 1.15 |
| Adhesion Promoter³ | 0.93 | 0.76 |
| Air Release Agent⁴ | -- | 0.17 |
| Rheology Modifier⁵ | -- | 1.12 |
| Gold Coated Polymer Conductive Filler⁶ | 10.00 | - |
| Nickel Conductive Filler⁷ | -- | 22.69 |

| | | |
|---|---|---|
| ¹NANOPOX commercially available from Hanse chemie ²K-PURE epoxy catalyst commercially available from King Industries ³SILQUEST 187, commercially available from GE Advanced Materials ⁴BYK 500, commercially available from BYK Chemie. ⁵Tone Polyol 0249, commercially available from Union Carbide. ⁶ Bright GNR-EH, commercially available from Nippon Chemical Industrial Co., LTD. ⁷ Bright GNM-Ni, commercially available from Nippon Chemical Industrial Co., LTD. | | |

The formulations were tested under four conditions as set out in Table 2.

**Table 2. Anisotropic Conductive Adhesive Test Conditions**

| Condition | Bonding Pressure (N) | Up Plate Temp (°C) | Low Plate Temp (°C) | Cycle Time (seconds) |
|---|---|---|---|---|
| 1 | 2 | 140 | 150 | 8 |
| 2 | 4 | 140 | 150 | 8 |
| 3 | 2 | 140 | 150 | 5 |
| 4 | 2 | 140 | 150 | 3 |

The samples were placed on dies and subjected to thermal shock performance testing. The test protocol was to cycle the temperature between -40°C and 85°C through 100 cycles. The results of the thermal shock testing are illustrated in Table 3.

**Table 3. Thermal Shock Testing Results**

| Sample | Condition | Initial Resistance (Mohm) | Resistance After Thermal Shock¹ (Mohm) |
|---|---|---|---|
| A | 1 | 1.50 | 1.40 |
| A | 2 | 1.40 | 1.39 |
| B | 1 | 1.26 | 1.49 |
| B | 3 | 1.22 | 1.45 |
| B | 4 | 1.49 | 1.71 |

| | | | |
|---|---|---|---|
| ¹ Thermal shock condition: -40°C to 85°C, 10min. dwell time, 100cycles | | | |

The thermal shock test results indicate that the anisotropic conductive adhesive of the present invention performs well and provides stable joint resistance under varying conditions.

The samples were placed on dies and subjected to thermal/humidity reliability testing. The testing involved placing the die/adhesive combination in an environment of 85°C and 85% relative humidity for 7 days. The results are shown in Table 4.

**Table 4. Thermal/Humidity Reliability Testing Results**

| Sample | Condition | Initial Joint Resistance | Final Joint Resistance |
|---|---|---|---|
| | | (Mohm) | (Mohm) |
| A | 1 | 1.6 | 1.6 |
| A | 2 | 1.4 | 1.4 |
| B | 1 | 1.3 | 1.35 |
| B | 3 | 1.2 | 1.4 |
| B | 4 | 1.2 | 1.35 |

The samples were placed on dies and tested for adhesion to antenna substrates. The antenna substrates consisted of 1.5 x 1.5 mm dies on silver ink PET antennas. The dies were tested for adhesion strength and the results are illustrated in Table 5.

**Table 5. Shear Strength Testing Results**

| Sample | Condition | Shear Strength |
|---|---|---|
| | | (kg) |
| A | 1 | 3.1 |
| A | 2 | 3.1 |
| B | 1 | 2.8 |
| B | 4 | 3.6 |

The shear strength test results show that both samples provide excellent adhesion to the antenna substrate and the silicon die. Further, both formulations maintained their adhesion strength regardless of the bonding conditions.

Many modifications and variations of this invention can be made without departing from its spirit and scope, as will be apparent to those skilled in the art. The specific embodiments described herein are offered by way of example only, and the invention is to be limited only by the terms of the appended claims, along with the full scope of equivalents to which such claims are entitled.

## Claims

1. A composition for use in microelectronic devices comprising one or more cationic curable resins, one or more thermal latent cationic catalysts, one or more conductive fillers and optionally a film forming thermoplastic solid resin.

2. The composition of claim 1 further comprising one or more nano size fillers from the group consisting of non-conductive fillers, conductive fillers or mixtures thereof.

3. The composition of claim 1, wherein the cationic curable resin is an epoxy resin.

4. The composition of claim 3, wherein the cationic curable epoxy resin comprises cycloaliphatic epoxy resin.

5. The composition of claim 4, wherein the cycloaliphatic epoxy resin comprises silica nanoparticle reinforced cycloaliphatic epoxy resin.

6. The composition of claim 1, wherein the one or more latent cationic catalysts include one or more super acid catalysts.

7. The composition of claim 1, wherein the one or more latent cationic catalyst is selected from the group consisting of ammonium/antimony hexafluoride, triarylsulfonium hexafluoroantimonate salt, triarylsulfonium hexafluorophosphate salt, (tolycumyl} iodonium tetrakis (pentafluorophenyl) borate, bis(dodecylphenyl)iodonium hexafluoroantimonate, ( iodonium,(4,-methylphenyl)(4-(2-methylpropyl)phenyl),hexafluorophosphate), octyl diphenyliodonium hexafluroantimonate, diaryliodonium salts, benzylsulfonium salts, phenacylsulfonium salts, N-benzylpyridinium salts, N-benzylpyrazinium salts, N-benzylammonium salts, phosphonium salts, hydrazinium salts, ammonium borate salts and mixtures thereof.

8. The composition of claim 1, further comprising corrosion inhibitors, curing agents, catalysts, reactive and/or non-reactive diluents, adhesion promoters or mixtures thereof.

9. The composition of claim 1, wherein the conductive fillers are selected from the group consisting of silver, copper, gold, palladium, platinum, nickel, gold or silver-coated nickel, carbon black, carbon fiber, graphite, aluminum, indium tin oxide, silver coated copper, silver coated aluminum, metallic coated glass spheres, metallic coated filler, metallic coated polymers, silver coated fiber, silver coated spheres, and antimony doped tin oxide and mixtures thereof.

10. The composition of claim 1, wherein the film forming thermoplastic solid resin is selected from the group consisting of epoxies, acrylics, phenoxy resin, thermoplastic polyesters, polyamides, polyurethanes, polyolefins, polysulfide rubber, nitrile rubber and mixtures thereof.

11. The composition of claim 2, wherein the nano size conductive fillers are selected from the group consisting of nano silver, nano aluminum, nano copper, nano nickel, carbon nanotubes and mixtures thereof.

12. The composition of claim 2, wherein the nano size non-conductive fillers are selected from the group consisting of nano silica, nano alumina, nano clay and mixtures thereof.

13. The composition of claim 1, wherein the one or more cationic curable resin comprises in the range of about 5 weight percent to about 98 weight percent of the composition.

14. The composition of claim 13, wherein the one or more cationic curable resin comprises in the range of about 40 to about 60 weight percent of the composition.

15. The composition of claim 1, wherein the one or more latent cationic catalyst comprises in the range of about 0.1 to about 10 weight percent of the composition.

16. The composition of claim 15, wherein the one or more latent cationic catalyst comprises in the range of about 0.5 to about 3 weight percent of the composition.

17. The composition of claim 1, wherein the one or more conductive filler comprises in the range of about 1 to about 60 weight percent of the composition.

18. The composition of claim 17, wherein the one or more conductive filler comprises in the range of about 5 to about 30 weight percent of the composition.

19. The composition of claim 2, wherein the composition comprises in the range of about 10 to about 60 weight percent of the one or more nano size fillers.

20. The composition of claim 19, wherein the composition comprises in the range of about 20 to about 40 weight percent of the one or more nano size fillers.

21. The composition of claim 1, wherein the composition comprises in the range of about 10 to about 80 weight percent of the film forming thermoplastic solid resin.

22. The composition of claim 21, wherein the composition comprises in the range of about 20 to about 50 weight percent of the film forming thermoplastic solid resin.

23. The composition of claim 1, wherein the composition is anisotropically conductive.

24. A method of bonding one or more electronic components comprising the step of applying an effective amount of the composition of claim 1 to an electronic component.

25. An electronic component containing the composition of claim 1.
